(19) Europäisches Patentamt
European Patent Office
Office européen des brevets

(11) EP 0 918 230 A1

# (12) EUROPEAN PATENT APPLICATION

(43) Date of publication:
26.05.1999 Bulletin 1999/21

(51) Int. Cl.[6]: G01R 35/00

(21) Application number: 98850168.0

(22) Date of filing: 03.11.1998

(84) Designated Contracting States:
AT BE CH CY DE DK ES FI FR GB GR IE IT LI LU MC NL PT SE
Designated Extension States:
AL LT LV MK RO SI

(30) Priority: 11.11.1997 SE 9704130

(71) Applicant: Nilsson, Ulf R. C.
224 72 Lund (SE)

(72) Inventor: Nilsson, Ulf R. C.
224 72 Lund (SE)

(74) Representative:
Bjerre, Nils B.J. et al
AWAPATENT AB,
P.O. Box 5117
200 71 Malmö (SE)

## (54) Method for finding errors of measurement in an energy distribution system

(57) The invention concerns a method for scanning a group of receivers of energy in an energy distribution system to find defective energy meters and energy-consuming installations at the receivers' place. For each receiver in the group, the following steps are performed:

- determining the energy consumption measured by the energy meter during an entire time cycle;
- determining the energy consumption measured by the energy meter during one or more subperiods of the time cycle; and
- determining for the subperiod (each subperiod) a comparative value which consists of a ratio ($LI_i$) of the energy consumption during the subperiod to the energy consumption during the entire time cycle;

Subsequently the following steps are performed:

- determining for the subperiod (each subperiod), by means of a statistical method, which of all comparative values are within a normal range and which are outside the normal range; and
- defining the energy meters whose comparative values are outside the range as belonging to a group having a great risk of defects.

FIG. 2

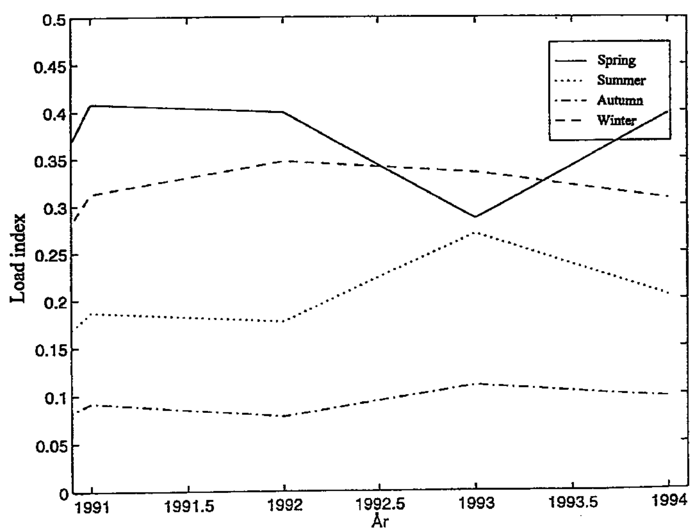


EP 0 918 230 A1

## Description

### Field of the Invention

The present invention concerns generally a method for finding errors of measurement in an energy distribution system, and more specifically a method as set forth in the preamble to claim 1.

### Background Art

In an energy distribution system for heating buildings, such as a gas network, a distant heating network or an electricity network, an energy meter measuring the energy consumption is to be found in connection with each energy-consuming installation in the form of a heating device or plant. By energy consumption is here meant the consumption of the medium, such as gas, water or electricity, that is supplied to the installation. The great majority of meters measure essentially correctly, but a certain part of the meters have a non-negligible error of measurement. The error of measurement may be caused, for instance, by the meter being damaged, worn or incorrectly installed. The error of measurement can be positive or negative for the producer, both cases being undesirable. Moreover, the heating device can be incorrectly installed, incorrectly dimensioned or in some other way have an incorrect function which gives rise to extraordinary consumption conditions, which also can be interpreted as errors of measurement.

It is of interest for all parties involved that the energy consumption is correctly measured. Prior-art technique implies that a selection of meters of a certain type and of a certain age is made, which are then dismounted and tested in a test bench. If more than a statistically determined number of them have an unacceptably great error of measurement, all meters in the network which are of the same type and of the same age or, where appropriate, older are exchanged.

This is an expensive method, but it would be still more expensive to test all meters that have reached a certain age and exchange just the defective ones. It is, of course, possible to test a meter in situ. This involves, however, with the techniques available a still higher cost than that of dismounting it and testing it in a test bench. Therefore, improving and making the test procedure less expensive is therefore desirable, thereby increasing the safety in the determination of which meters need be exchanged. This reduces the risk of faultless meters being exchanged.

### Summary of the Invention

The object of the invention is to provide a cost-effective method for finding defective meters and installations in an energy distribution system, said method identifying individual defective objects in a considerably better way than does prior-art technique.

The object is achieved by a method having the features defined in claim 1. Preferred embodiments of the invention are defined in the subclaims.

According to the present invention, installations in a distribution system are studied and the consumption which the energy meter of the installation records during a time cycle, during a subperiod or a plurality of subperiods of the time cycle, is determined. A time cycle is a period of time whose operating conditions are repeated periodically, for instance one year. During a year, the operating conditions vary considerably between cold winter and warm summer, but these variations recur every year. Deficiencies of various types are discovered by means of the invention by yielding a non-linear or in some other manner abnormal effect on the measured consumption in varying operating conditions.

The determined ratio of energy consumption during a subperiod to a time cycle yields a comparative value of one installation which is directly comparable with the comparative values of other installations that are determined for the same subperiod. The comparative values are independent of the different heating needs of different buildings and different habits and needs of people in different households.

It is easy to determine the energy consumption measured by the energy meter since the meters are read at regular intervals. If extra readings are required for application of the inventive method, this involves a negligible additional cost using today's reading methods, compared with the saving in costs achieved by using the method. By the method being based on the readings and not on actual testing of a selection of meters based on the age of the meters, several advantages are achieved. For instance, a large number of receivers can be included in the scanning, which would be far too expensive with the prior-art method described above and with other known methods, and the risk of unnecessarily testing correctly operating meters and installations is limited. When using the prior-art method, most of the tested meters, however, operate well owing to the random character of the method, which means that expensive tests are performed without cause.

### Brief Description of the Drawings

The invention and additional advantages thereof will now be described in more detail by way of embodiments and with reference to the accompanying drawings, in which

Fig. 1 is a histogram of comparative values of the registered consumption of different energy meters; and

Fig. 2 shows variations in the comparative value of an energy meter.

Description of Embodiments

A preferred embodiment as well as alternative embodiments of the invention will now be described.

With a view to facilitate understanding, reference is made to an example in the form of a practically performed scanning operation. It was performed on 1274 receivers in a gas distribution network in a town. Receivers were households which entirely or mainly used the gas for heating houses and flats. Thus, the installations were gas-fired boilers. In such a gas network there is always a difference between the amount of distributed gas and that of consumed gas. At each receiver's, i.e. consumer's, place the consumption of gas is measured with the aid of an energy meter which registers the gas flow therethrough. The difference depends mainly on sources of error, such as leakage, errors of measurement, theft and wrong debiting. Investigations that have been carried out in recent years prove that the predominant source of error is errors of measurement at the consumer's place. By using the present method, a large part of the errors of measurement and also other types of sources of error can be traced without necessitating practical tests on the meters. Instead scanning of the receivers that one wants to check is carried out and those having an abnormal consumption pattern are sorted out. Only the meters and installations of the sorted-out receivers are defined to belong to a group involving a great risk of defects and are subjected to practical tests. However, it should be mentioned that the method has the best accuracy in finding errors when some basic requirements are satisfied, i.e. most of the meters scanned must have an acceptable accuracy, climatic variations where the scanning is carried out must have a periodic pattern, and the energy consumption of the population studied must have a normal gaussian distribution. These factors are normally satisfied, like in the example described here.

According to the preferred embodiment of the invention, a first step is carried out, in which the length of the time cycle is determined, in this example one year. In a second step, the length of the subperiod as well as the number of subperiods that are to be examined are determined. In the example, the subperiod was a quarter of a year, and all four quarters of the year were analysed. The choice of the length of the time cycle depends on climatic variations. In the test place, one year is a climatic cycle and thus is a suitable time cycle. The choice of the length of the subperiod depends on what one wants to achieve. As a rule it may be said that it should be sufficiently long to be representative. By this is meant that individual receivers' occasional deviations from normal patterns, for instance a weekend's absence, do not affect the result to any considerable extent. In a third step, the energy consumption of the entire time cycle with one of the receivers that are to be scanned is determined. In a fourth step, the energy consumption of the receiver is determined during a subperiod. The easiest way of determining the consumption is to take out the read settings of the meters or, if these values are not available, to make readings, i.e. the scanning extends for some time ahead. Today's technique makes the reading procedure fairly simple. Methods for remote reading which further simplify the reading procedure are gaining ground.

According to the method, the meters of different receivers, or consumers, are compared with each other. This is achieved by determining, in the next step of the method, a ratio of the consumption values for the subperiod to the time cycle, which eliminates the effect of different energy needs of different consumers. The differences depend on a number of factors, such as houses and flats of different size, different wishes for indoor temperature, differently well insulated houses and flats, gas-fired boilers with different degrees of efficiency. One way would be to group consumers having equivalent housing conditions and equivalent gas-fired boilers. In addition to ensuing considerable restrictions of the number of consumers in a group, there still remain relatively great variations caused by different wishes for indoor temperature, different airing habits etc.

According to the preferred embodiment of the invention, the effect of the above-mentioned factors is instead eliminated by the value of the consumption during a subperiod, i.e. in the example a quarter of a year, being divided by the value of the consumption during the entire time cycle, i.e. during the year. This can be expressed mathematically as follows:

$$LI_i = \frac{C_i}{\sum_{t=1}^{n} C_i} \qquad (1)$$

wherein $LI_i$ is below referred to as load index, i represents a certain subperiod, here i=1, 2, 3 or 4, $c_i$ is the consumption of gas during the subperiod i for an individual consumer, and n is the number of subperiods examined, here n=4, which together constitute a time cycle.

The load index $LI_i$ is then determined in the same way as above for the rest of the consumers for the same subperiod. The next step is a statistical analysis to sort out the load indices which indicate abnormal conditions, which probably are caused by some defect in the meter or in the actual gas-fired boiler. The analysis thus involves a comparison between the load indices $LI_i$ of the consumers. According to the preferred embodiment, the sorting-out is achieved by determining percentiles which cut off extreme values in both ends of a range. Fig. 2 shows a histogram of load indices for the 1274 consumers' energy meters in the example. The consumption values in the example, which was carried out in accordance with this embodiment of the invention, were collected in 1994. The time cycle is the entire year 1994, and the subperiod for which load indices in Fig. 2 were calculated is the first quarter. In accordance with this embodiment, extreme value limits were in the statistical analysis determined at the 5% and the 95% percentile, respectively. The extreme values are in the example the load indices $LI_i$ which are lower than 0.311 and higher than 0.482. They represent a limited number of all the consumers' meters and are sufficiently few to make it profitable to let them be the subject of a testing for defects, i.e. check them to find out whether the meters have insufficient accuracy owing to defects in the meters or if there is some other fault in the installation.

In the example, practical tests were carried out on the meters which the method indicated to belong to a group with a great risk of defects, i.e. the meters in the extreme value group. It was found that about 40% of the meters had some sort of defect that resulted in inacceptable accuracy. This percentage in respect of defects was more than 8 times higher than in a comparative group with randomly selected meters. At the same time cases of correct meters appeared, in which a further examination of the installation itself showed that it was performed in an incorrect manner. This confirmed that the method is also capable of pointing out incorrect installations.

It should be mentioned that other factors which can also yield deviating load indices, but which cannot be referred to as defects in the sense intended here may occur. One such factor is that the inhabitants move out and new ones move in. Another factor is consumers shifting between different sources of energy and, for instance, utilising an air pump during parts of the year. One more factor is that the house is provided with supplementary insulation. The major part of these factors are available as information in the reading reports. This eliminates checking which has no ground in a real defect. A further or supplementary possibility is studying the measured consumption of the installation during a plurality of time cycles and proceeding in accordance with an alternative embodiment of the invention.

This alternative embodiment consists of the embodiment described above supplemented with additional steps. Having the load indices $LI_i$ as a basis, the average value $\overline{LI}_i$ of the comparative values of the group is determined, i.e. the load index $LI_i$. This makes it possible to determine for each energy meter a normalised comparative value, or a normal load index, $LI_n$, as a ratio of the load index $LI_i$ of the installation to the average value $\overline{LI}_i$, preferably as follows:

$$\overline{LI}_i = \frac{\sum_1^M C_i}{\sum_1^M \sum_1^n C_i} = \frac{1}{M}\sum_1^M LI_i \qquad (2)$$

wherein M is the number of installations included in the examination; and

$$LI_i = \frac{LI_i}{\overline{LI}_i} \qquad (3)$$

Normal load indices $Li_n$ for different years can thus be compared with each other. They can in fact vary to quite a considerable extent, not only from subperiod to subperiod but also from year to year, but in most cases the variations are small, see Fig. 3. In Fig. 3, four years are represented by four subperiods each year, each curve illustrating the variations of a subperiod from year to year. Comparisons over a plurality of time cycles also eliminate many extreme values of a temporary kind, such as the above-mentioned change of inhabitants or installations which have temporarily not been working during one or a few subperiods in which they are usually in operation. The normal load index $LI_n$ should be as close to 1 as possible.

When load indices $LI_i$ and normal load indices $LI_n$ are determined and used according to the inventive method, they are thus usable tools to secure independence of variations in respect of consumers and climate and, with a good dividend, both to find defective meters and installations and to sort out those which for temporary reasons have obtained load indices which are in the group of extreme values.

The inventive method is, of course, not limited to the embodiments described above and may assume many different variants within the scope of the invention as defined in the appended claims. For instance, many different statistical methods of analysing are thus conceivable in addition to the percentile analysis described above. Another example is determining confidence ranges or average values $\pm 2\sigma_s$.

## Claims

1. A method for scanning a group of receivers of energy in an energy distribution system to find defective energy meters and energy-consuming installations at the receivers' place, **characterised** by performing, for each receiver in the group, the steps of:

   - determining the energy consumption measured by the energy meter during an entire time cycle;
   - determining the energy consumption measured by the energy meter during one or more subperiods of the time cycle; and
   - determining for the subperiod (each subperiod) a comparative value which consists of a ratio ($LI_i$) of the energy consumption during the subperiod to the energy consumption during the entire time cycle;

and by the steps of:

- determining for the subperiod (each subperiod), by means of a statistical method, which of all comparative values are within a normal range and which are outside the normal range; and
- defining the energy meters whose comparative values are outside the range as belonging to a group having a great risk of defects.

**2.** A method as claimed in claim 1, **characterised** by the steps of

- determining the average value ($\overline{LI}_i$) of the comparative values of the group; and
- determining for each energy meter a normalised comparative value ($LI_n$) as a ratio of the comparative value of the energy meter to the average value.

FIG.1

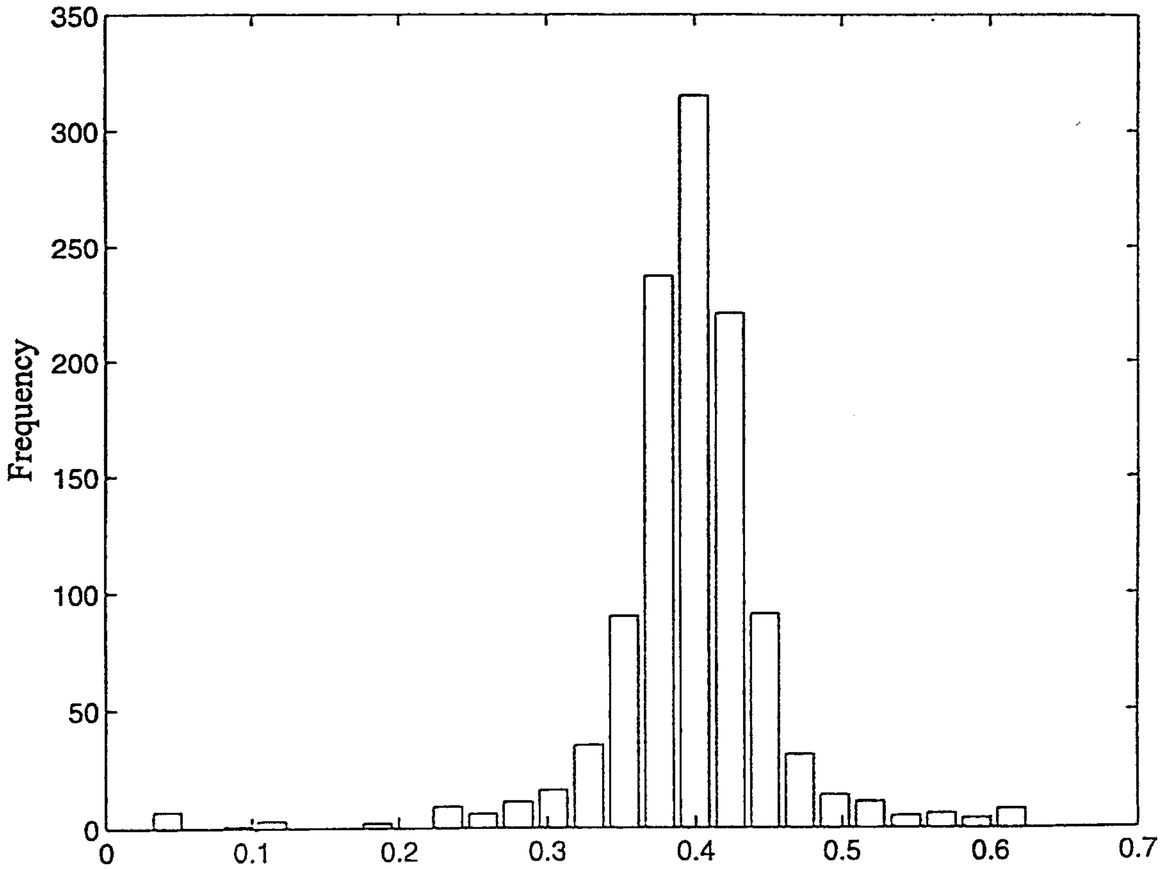

FIG. 2

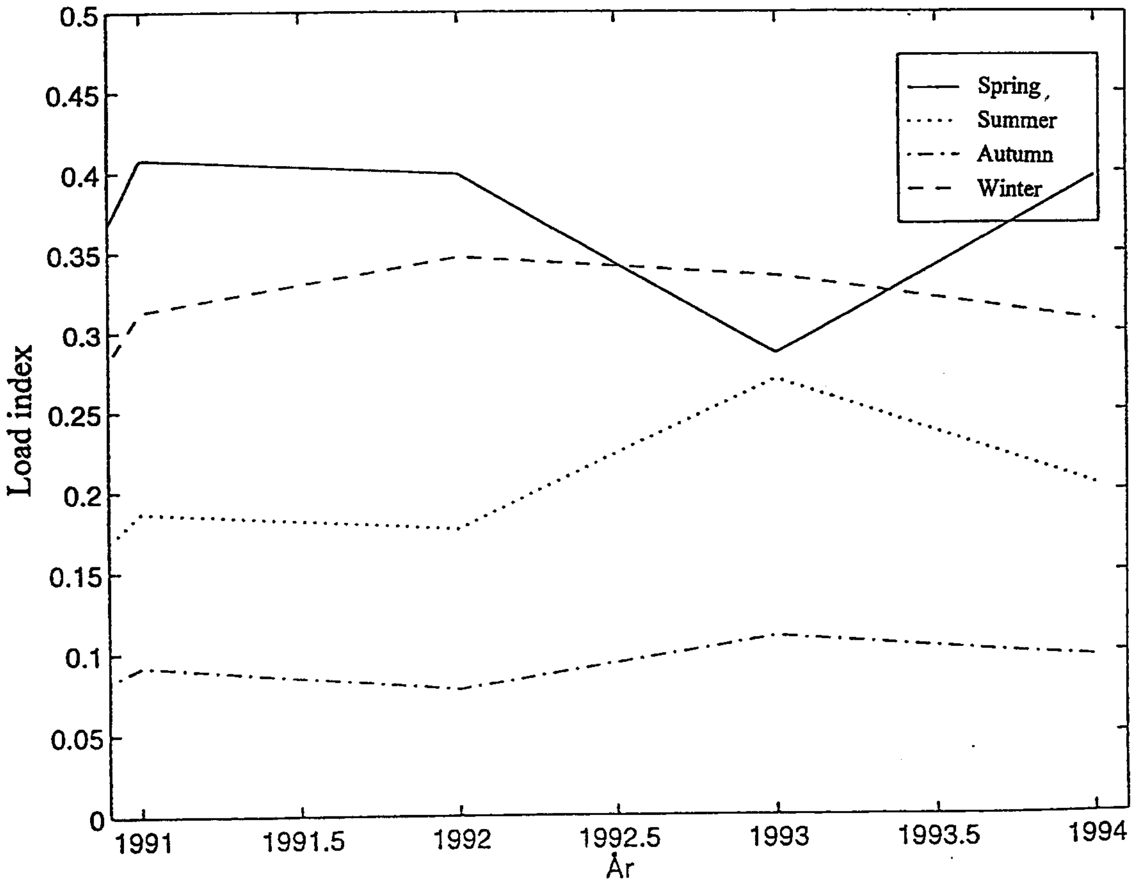
0.5
0.45
0.4
0.35
0.3
0.25
0.2
0.15
0.1
0.05
0
Load index
1991
1991.5
1992
1992.5
1993
1993.5
1994
År
Spring,
Summer
Autumn
Winter

European Patent Office

# EUROPEAN SEARCH REPORT

Application Number
EP 98 85 0168.0

## DOCUMENTS CONSIDERED TO BE RELEVANT

| Category | Citation of document with indication, where appropriate, of relevant passages | Relevant to claim | CLASSIFICATION OF THE APPLICATION (Int. Cl.6) |
|---|---|---|---|
| A | DD 225807 A1 (AKADEMIE DER WISSENSCHAFTEN DER DDR), 7 August 1985 (07.08.85) * The last two portions of page 1 and the first two portions of page 2 * ----- | 1,2 | G01R 35/00 |

TECHNICAL FIELDS SEARCHED (Int. Cl.6)
G01R

The present search report has been drawn up for all claims

| Place of search | Date of completion of the search | Examiner |
|---|---|---|
| STOCKHOLM | 3 February 1999 | WIRLÉE SVEN-OLOF |

CATEGORY OF CITED DOCUMENTS

X : particularly relevant if taken alone
Y : particularly relevant if combined with another document of the same category
A : technological background
O : non-written disclosure
P : intermidiate document

T : theory or principle underlying the invention
E : earlier patent document, but published on, or after the filing date
D : document cited in the application
L : document cited for other reasons

& : member of the same patent family, corresponding document

EPO FORM 1503 03.82 (P0401)

# ANNEX TO THE EUROPEAN SEARCH REPORT ON EUROPEAN PATENT APPLICATION NO. EP 98 85 0168.0

This annex lists the patent family members relating to the patent documents cited in the above-mentioned European search report.
The members are as contained in the European Patent Office EDP file on 21/12/98
The European Patent Office is in no way liable for these particulars which are merely given for the purpose of information.

| Patent document cited in search report | Publication date | Patent family member(s) | Publication date |
|---|---|---|---|
| DD 225807 A1 | 07/08/85 | NONE | |

EPO FORM P0459

For more details about this annex : see Official Journal of the European Patent Office, No. 12/82